# EUROPEAN PATENT SPECIFICATION

(11) **EP 0 544 069 B1**
(45) Date of publication and mention of the grant of the patent: **12.11.1997**
(21) Application number: 92115194.0
(22) Date of filing: 04.09.1992
(51) Int. Cl.: G02F 1/136, H01L 29/772, H01L 21/336

(54) **Thin-film transistor panel and method of manufacturing the same**
Dünnschicht-Transistor-Panel und dessen Herstellungsmethode
Panneau de transistor à couches minces et sa méthode de fabrication

(30) Priority: 26.11.1991 JP 335553/91; 27.11.1991 JP 335875/91; 13.12.1991 JP 351328/91
(43) Date of publication of application: 02.06.1993
(73) Proprietor: CASIO COMPUTER COMPANY LIMITED, Shinjuku-ku Tokyo 160 (JP)
(72) Inventor: Matsuda, Kunihiro, c/o Hamura R & D Center, Hamura-shi, Tokyo 190-11 (JP)
(74) Representative: Grünecker, Kinkeldey, Stockmair & Schwanhäusser Anwaltssozietät

(56) References cited:
- EP-A- 0 361 609
- EP-A- 0 372 821
- US-A- 4 624 737
- PATENT ABSTRACTS OF JAPAN vol. 10, no. 367 (E-462)(2424) 9 December 1986 & JP-A-61 164 267
- PATENT ABSTRACTS OF JAPAN vol. 10, no. 255 (E-433) 2 September 1986 & JP-A-61 084 057
- PATENT ABSTRACTS OF JAPAN vol. 13, no. 279 (P-891)(3627) 27 June 1989 & JP-A-10 68 730

## Description

The present invention relates to a thin-film transistor panel for use in an active matrix liquid-crystal display according to the preamble part of claim 4 and a method for manufacturing same as set forth in the preamble part of claim 1.

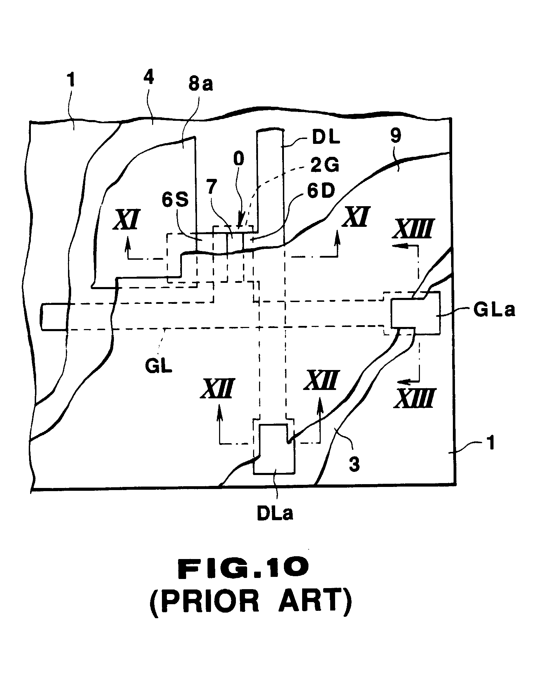

Generally, a thin-film transistor panel (herein after referred to as "TFT panel") designed for use in an active matrix liquid-crystal display, has a specific structure which will be described with reference to Figs. 10 to 13.

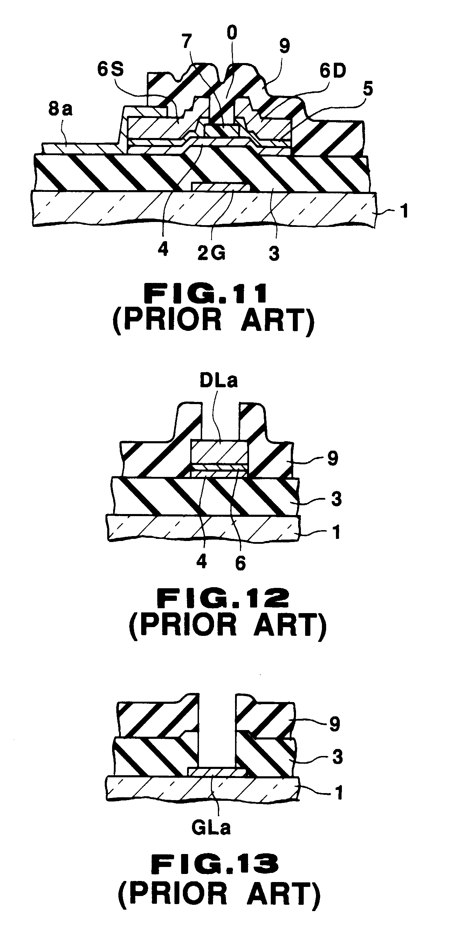

Fig. 10 is a plan view showing a part of the TFT panel, and Figs. 11, 12 and 13 are enlarged, cross-sectional views of the TFT panel, taken along lines XI-XI, XII-XII and XIII-XIII in Fig. 10, respectively.

The conventional TFT panel comprises a transparent substrate 1 made of glass or the like, a number of pixel electrodes 8a formed on the substrate 1, a number of thin-film transistors (TFTs) 0 functioning as active elements, a gate line GL connected to the gate electrodes 2G of the thin-film transistors 0, and a drain line (i.e., data line) DL connected to the drain electrodes 6D of the thin-film transistors 0.

The thin-film transistors 0 have a structure generally known as "inverse stagger structure." As is shown in Figs. 10 and 11, each thin-film transistor comprises a gate electrode 2G formed on the substrate 1, a gate-insulating film 3 covering the gate electrode 2G, an i-type semiconductor layer 4 formed on the gate-insulating film 3 and opposing the gate electrode 2G, an n-type semiconductor layer 5 formed on the i-type semiconductor layer 4, a source electrode 6S formed on one end portion of the n-type semiconductor layer 5, a drain electrode 6D formed on the other end portion of the n-type semiconductor layer 5. The channel region (i.e., the portion extending between the electrodes 6S and 6D) of the n-type semiconductor layer 5 has been removed, forming two n-type semiconductor layers.

The gate electrode 2G is integral with the gate line GL formed on the substrate 1. The gate line GL and the gate electrode 2G are made of metal such as Al, an Al alloy, Cr, or Ta. The gate-insulating film 3 is made of SiN (silicon nitride) or the like. The i-type semiconductor layer 4 is made of a-Si (amorphous silicon), and the n-type semiconductor layer 5 is made of a-Si doped with an n-type impurity.

A blocking layer made of SiN or the like is formed on the channel region of the i-type semiconductor layer 4. The blocking insulation layer 7 is provided to prevent the channel region of the i-type semiconductor layer 4 from being removed when the corresponding region of the n-type semiconductor layer 5 formed on the layer 4 is etched.

The gate-insulating film 3 of each thin-film transistor 0 is formed on the substrate 1, covering the gate line GL. The pixel electrode 8a and the drain lien DL are formed on the gate-insulating (transparent) film 3.

The drain line DL is integral with the drain electrode 6D of each thin-film transistor 0. The drain line DL, the drain electrode 6D, and the source electrode 6S are made of metal such as Al, an Al alloy, Cr, or Ta.

The pixel electrode 8a is formed of a transparent conductive film of ITO or the like. This electrode 8a has one terminal portion located on the source electrode 6S and, hence, is electrically connected to the source electrode 6S.

Thin-film transistor 0 and the drain line DL on the gate-insulating film 3 are covered with a protective insulation film 9 which is made of SiN or the like. The film 9 is formed on the entire surface of the substrate 1, except for the pixel electrode 8a. The terminal portion DLa of the drain line DL is exposed by removing that portion of the film 9 which is located above the portion DLa, as is shown in Figs. 10 and 12. The terminal portion GLa of the gate line GL is exposed by removing that portion of the gate-insulating film 3 which is located on the terminal protion GLa and also that portion of the protective insulation film 9 which us located above the terminal portion GLa, as is shown in Figs. 10 and 13.

The conventional TFT panel is manufactred by the following method.

### [Step 1]

First, a gate-forming metal film is formed on the substrate 1. This metal film is patterned by photolithography, thereby forming the gate lines GL and the gate electrode 2G.

### [Step 2]

The gate-insulating film 3 is formed on the substrate 1, covering the gate lines GL and the gate electrode 2G. Further, the i-type semiconductor layer 4 is formed on the gate-insulating film 3, and the blocking layer 7 is formed on the i-type semiconductor layer 4.

### [Step 3]

Next, the blocking layer 7 is patterned by photolithography, forming blocking layers covering only the channel region of the i-type semiconductor layers 4.

### [Step 4]

The n-type semiconductor layer 5 is formed, covering the entire surface of the unfinished product. Further, a metal layer is formed on the n-type semiconductor layer 5.

### [Step 5]

The metal film and the n-type semiconductor layer 5 are patterned by means of photolithography, forming the source electrodes 6S, the drain electrodes 6D and the drain lines DL. At the same time, the i-type semiconductor layer 4 is patterned, forming i-type semiconductor layers which define transistor regions.

Since the channel region of the n-type semiconductor layer 5 is located on the blocking layer 7, which in turn is located above the i-type semicondcutor layer 4, the i-type semiconductor laeyr 4 is not etched or damaged when the channel region of the n-type semiconductor layer 5 is removed by etching. The i-type semiconductor layer 4 remains not only in the transistor region, but also beneath the entire drain line DL.

### [Step 6]

Next, the transparent conductive film of ITO or the like is formed on the gate-insulating film 3, covering the source electrode 6S, the drain electrode 6D and the drain line DL.

### [Step 7]

The transparent conductive film is patterned by photolithography, thereby forming the pixel electrodes 8a.

### [Step 8]

Thereafter, the protective insulation film 9 is formed.

### [Step 9]

The protective insulation film 9 is patterned by photolithography, whereby its portions located on the pixel electrodes 8a and its portions located above the terminal portions DLa of the drain lines DL, and the terminal portion GLa of the gate line GL are removed. At the same time, that portion of hte gate-insulating film 3 which is located on the terminal portion GLa of the gate line GL is removed. Thus, the terminals portions DLa and GLa are thereby exposed. As a result, The TFT panel is manufactured.

In the method of manufacturing the conventional TFT panel, as many as five resist masks must be formed in order to manufacture the TFT panel. With this method, therefore, the TFT panel is manufactured but with low efficiency and at high cost. More specifically, the five resist masks are formed, respectively before:
(1) The gate metal film is patterned;
(2) The blocking layer 7 is patterned;
(3) The metal film 16 is patterned to form the source electrodes 6S and the drain electrodes 6D, and the n-type semiconductor layer 15 and the i-type semiconductor layer 14 are patterned;
(4) The transparent conductive film is patterned;
(5) The protective conductive film 9 is patterned.

Use of five resist masks leads to the necessity of preparing and using five exposure masks. The cost of preparing these exposure masks is another factor of increasing the manufacturing cost of the TFT panel.

The object of the present invention is to provide a TFT panel having a simplified structure and to provide a method for manufacturing same at low costs.

This object is solved by a method having the steps of claim 1 and a TFT panel having the features of claim 4.

This invention can be more fully understood from the following detailed description when taken in conjunction with the accompanying drawings, in which:
Figs. 1A to 1E are cross-sectional views explaining a method of manufacturing a thin-film transistor panel;
Fig. 2 is a plan view showing a thin-film transistor panel;
Figs. 3A to 3F are cross-sectional views, explaining a method of manufacturing the thin-film transistor panel according to an embodiment of the invention;
Fig. 4 is a plan view of the thin-film transistor panel according to the embodiment of the present invention;
Fig. 5 is a plan view of a further thin-film transistor panel;
Figs. 6 to 8 are cross-sectional views of the thin-film transistor panel taken along line VI-VI, VII-VII, and VIII-VIII in Fig. 5, respectively;
Figs. 9A to 9H are cross-sectional views explaining a method of manufacturing the thin-film transistor panel;
Fig. 10 is a plan view of a conventional thin-film transistor panel; and
Figs. 11 to 13 are cross-sectional views showing the conventional thin-film transistor panel, taken along lines XI-XI, XII-XII, and XIII-XIII in Fig. 10, respectively.

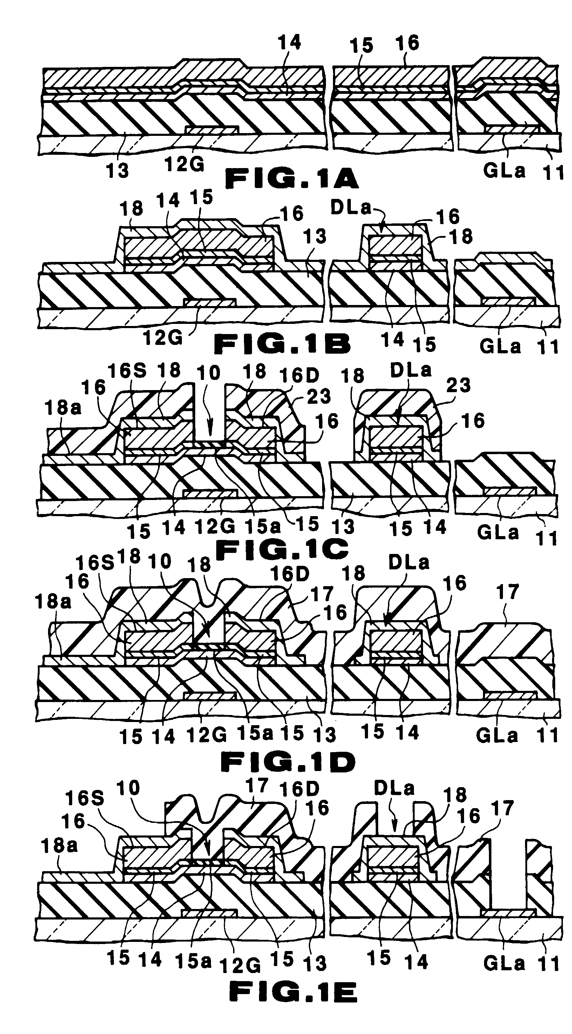

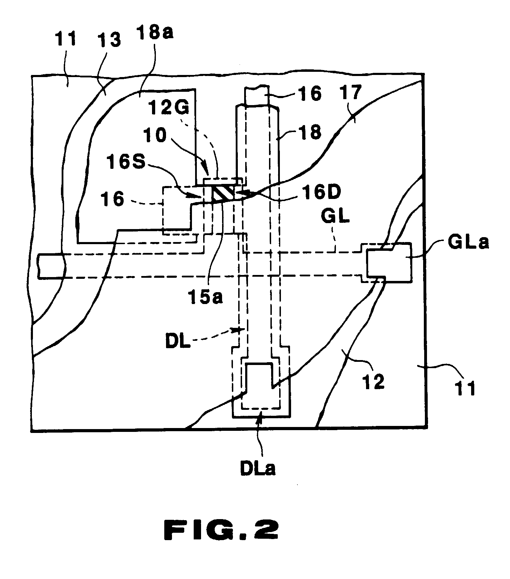

A thin-film transistor formed on one of the transparent substrates of an active matrix liquid-crystal display and designed for use as the active element for a pixel electrode, and an array thin-film transistors of this type (i.e., a TFT array), will be described with reference to Figs. 1A to 1E and Fig. 2.

Figs. 1A to 1E are cross-sectional views, each showing the thin-film transistor element and terminal portions of drain and gate lines of a TFT panel. Fig. 2 is a plan view of the thin-film transistor element and the terminals portions of the drain and gate lines. [Step 1]

As is shown in Fig. 1A, a gate metal film of Al, an Al alloy, Cr, Ta, or the like is formed on a transparent substrate 11 made of glass or the like. The gate metal film is patterned by photolithography, forming a gate line GL and a gate electrode 12G as is shown in Fig. 2. In Fig. 1A, GLa is the terminal portion of the gate line GL.

### [Step 2]

Next, as is shown in Fig. 1A, a gate-insulating film 13 made of SiN or the like is formed on the substrate 11, covering both the gate line GL and the gate electrode 12G. An i-type semiconductor layer 14 is then formed on the gate-insulating film 13. Further, an n-type semiconductor layer 15, which is made of a-Si doped with an n-type impurity, is formed on the i-type semiconductor layer 14. Still further, a metal film 16 made of Al, an Al alloy, Cr, Ta, or the like is formed on the n-type semiconductor layer 15. The film 16 will be processed to form a source electrode and a drain electrode.

### [Step 3]

Then, as is shown in Fig. 1B, the metal film 16, the n-type semiconductor layer 15, and the i-type semiconductor layer 14 are patterned by photolithography, each into two portions having substantially the same size and shapes as a drain line DL (see Fig. 2) and a transistor region. In Fig. 1B, DLa is the terminal portion of the drain line DL.

### [Step 4]

As is shown in Fig. 1B, too, a transparent conductive film 18 made of ITO or the like is formed on the gate-insulating film 13, thus covering the the metal film 16, already patterned.

### [Step 5]

Next, as is shown in Fig. 1C, a resist mask 23 is formed on the the transparent conductive film 18. Using the mask 23, the film 18 is patterned by means of photolithography, into three portions. These three portions have the substantially the same sizes and shapes as a source electrode 16S, a drain electrode 16D, and a drain line DL, respectively, which will be formed. Using the resist mask 23 again, the metal film 16 located on the region of the transistor element is selectively etched, forming the source electrode 16S and the drain electrode 16D.

The source electrode 16S, the drain electrode 16D, and the drain line DL, which have been formed in Steps 3 to 5, consist of two layers, the lower layer being a part of the metal film 18, and the upper layer being a part of the transparent conductive film 18. A portion of the n-type semiconductor layer 15 remains beneath the drain line DL including the terminal portion DLa thereof. Also, a portion of the i-type semiconductor layer 14 remains below the drain line DL.

The transparent conductive film 18 is patterned into portions on the source electrode 16S, the drain electrode 16D and the drain line DL, these portions being a little broader than the the electrodes 16S and 16D and the drain line DL. As a result of this, the film 18 covers the electrodes 16S and 16D entirely, but the opposing sides thereof, and covers the drain line DL entirely.

### [Step 6]

As is shown in Fig. 1C, using the resist mask 23 once used in patterning the transparent conductive film 18, the n-type semiconductor layer 15 is oxidized anodically, thereby electrically isolating those two parts of the layer 15 which are located beneath the source electrode 16S and the drain electrode 16D. A thin-film transistor element 10 is thereby made.

The anodic oxidation of the n-type semiconductor layer 15 is accomplished by immersing the layer 15 in an electrolytic solution, opposing the layer 15, acting as anode, to a platinum electrode (not shown) also immersed in the electrolytic solution and functioning as cathode, and applying a voltage between the layer 15 and the platinum electrode. That portion of the layer 15, which is not covered with the resist mask 23 and which contacts the electrolytic solution, undergoes a chemical reaction and is oxidized anodically. Said portion of the n-type semiconductor layer 15 is thereby changed to an insulation layer 15a.

The depth to which the n-type semiconductor layer 15 is oxidized depends, mainly on the voltage applied between the layer 15 and the platinum electrode. Hence, the selected portion of the layer 15 is anodically oxidized entirely in its thickness direction, provided that a voltage proportional to the thickness of the layer 15 is applied between the n-type semiconductor layer 15 and the platinum electrode (not shown). This is why the two parts of the layer 15, located beneath the electrodes 16S and 16D, are electrically isolated from each other.

An electric current can be supplied to the layer 15 in order to anodically oxidize said portion of the layer 15, through the metal film 16, the transparent conductive film 18 formed on the metal film 16 and the drain electrode 16D (i.e., a part of the metal film 16). Therefore, the n-type semiconductor layers 15 of all thin-film transistor elements which are arranged along the data line DL can be anodically oxidized uniformly.

### [Step 7]

Next, the resist mask 23 is removed, and a protective insulation film 17 made of SiN or the like is formed on the substrate 11, thus covering all components formed on the substrate 11, as is shown in Fig. 1D.

### [Step 8]

As is shown in Fig. 1E, the protective insulation film 17 is patterned by photolithography, such that its portion on the pixel electrode 18a, its portion on the terminal portion DLa of the drain line DL, and its portion on the terminal portion GLa of the gate line GL are removed. At the same time, that portion of the gate-insulating film 13 which is located on the terminal portion GLa of the gate line GL is removed by means of etching, thereby exposing the pixel electrode 18a, the terminal portion DLa of the drain line DL, and the terminal portion GLa of the gate line GL. Thus, a TFT panel is manufactured.

In the method of manufacturing the TFT panel, described above, that portion of the n-type semiconductor layer 15, which extends between the source electrode 16S and the drain electrode 16D, is oxidized anodically, becoming an insulative layer 15a and electrically dividing the layer 15 into two portions. In other words, no part of the n-type semiconductor layer 15 is not etched away to form two n-type semiconductor layers. Hence, no damage is done to the i-type semiconductor layer 14, without forming a blocking layer on the channel region of the i-type semiconductor layer 14. The method need not have a step of forming such a blocking layer.

In the method of manufacturing a TFT panel, described above, it suffices to form only four resist masks, whereas five resist masks must be formed in the conventional method. More specifically, the four resist masks are formed, respectively before:
(1) The gate metal film is patterned;
(2) The metal film 16, the n-type semiconductor layer 15, and the i-type semiconductor layer 14 are patterned into portions having the same shape as the drain line DL and into portions having the same shape as the transistor region;
(3) The transparent conductive film 18 is patterned, the metal film 16 is divided, and the n-type semiconductor layer 15 is partly oxidized anodically;
(4) The protective insulation film 17 is patterned.

Therefore, the TFT panel can be manufactured without damaging the i-type semiconductor layer 14 and requiring less resist masks, thus with high efficiency and at low cost.

Further, since no blocking layer needs to be formed on the channel region of the i-type semiconductor layer 14, it is possible with the method to manufacture TFT panels at a higher yield than is possible with the conventional method.

In the conventional method, the etching solution applied for patterning, by photolithography, the blocking layer formed on the i-type semiconductor layer etching the blocking layer leaks to the gate-insulating film though pinholes, if any, made in the i-type semiconductor layer, inevitably forming pinholes in the gate-insulating film. These pinholes result in the short-circuiting in the thin-film transistor or at the intersections of lines (e.g., short-circuiting between the gate electrode and the source or drain electrode, and the short-circuiting between the gate line and the drain line). Consequently, the net yield of TFT panels is low.

By contrast, in the method described herein, no blocking layer is formed on the i-type semiconductor layer, and no step is performed to pattern such a blocking layer. It follows that the gate-insulating film need not be etched at all, for patterning such a blocking layer. Hence, no inter-layer short-circuiting occurs, whereby TFT panels can be manufactured at a high yield.

In addition, the method is characterized in that the portion of the n-type semiconductor layer, which extends between the source and drain electrodes, is anodically oxidized, becoming an insulative layer electrically dividing the n-type layer into two conductive layers. Therefore, the i-type semiconductor layer is not damaged during the manufacture of the TFT panel, and a step of forming a blocking layer is unnecessary.

Since only four resist masks need to be formed in the method of the present invention, the TFT panel can manufactured with higher efficiency and, hence, at lower cost, than in the conventional method in which four resist masks must be formed to manufacture a TFT panel of the same type.

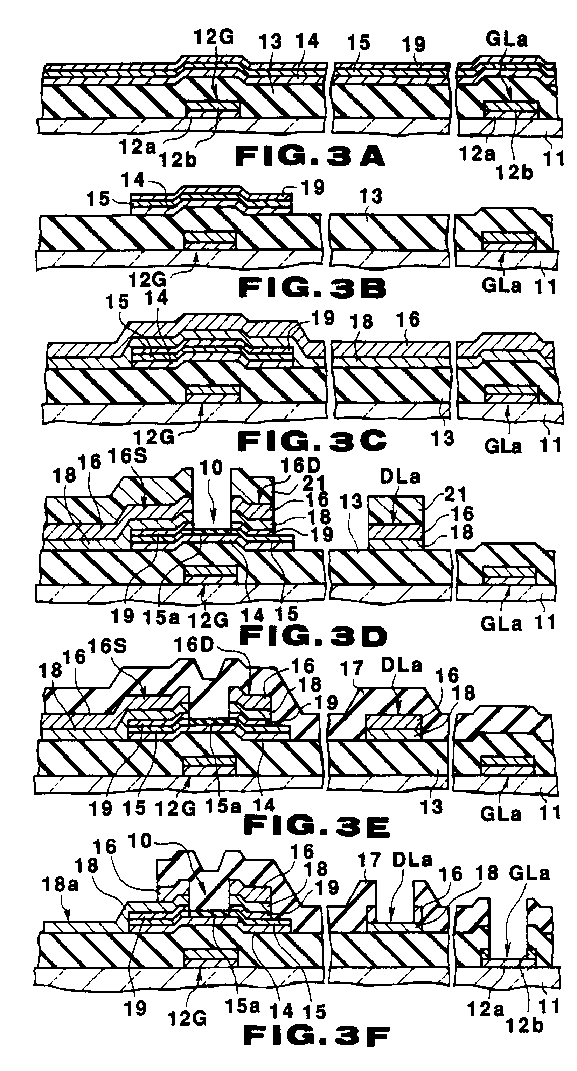

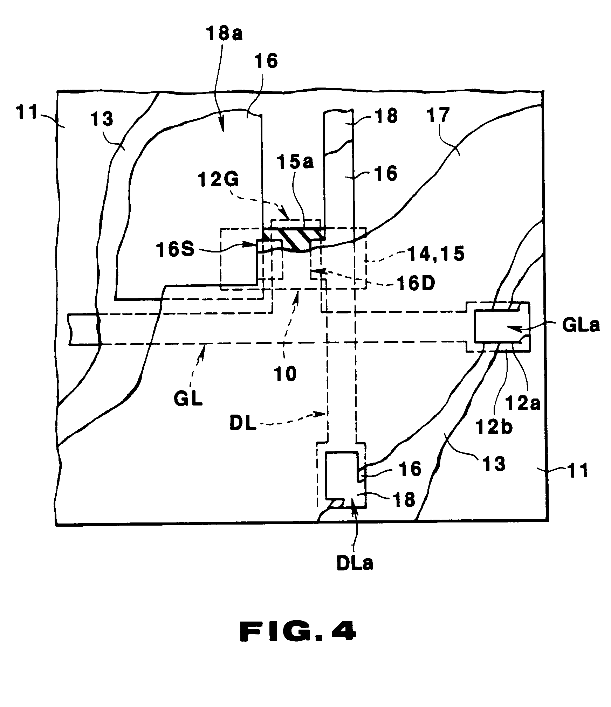

A method of manufacturing a TFT panel, which is an embodiment of the invention, will now be described with reference to Figs. 3A to 3F and Fig. 4. Figs. 3A to 3F are cross-sectional views explaining this method, and Fig. 4 is a plan view of the thin-film transistor panel made by this method.

### [Step 1]

As is shown in Fig. 3A, a gate line GL (Fig. 4) and a gate electrode 12G are formed on a transparent substrate 11 made of glass or the like. The gate line GL consists of a lower film 12a and an upper film 12b, and the gate electrode 12G also consists of a lower film 12a and an upper film 12b. Each lower film 12a is formed on the substrate 11 and made of ITO or the like, and each upper film 12b formed on the lower film 12a and made of Al or an Al alloy. The gate line GL and the gate electrode 12G have been made by forming a lower film on the substrate 11 and an upper film on the lower film and then by patterning both films by means of photolithography.

### [Step 2]

Next, as is seen in Fig. 3A, too, a gate-insulating film 13 made of SiN or the like is formed on the substrate 11, covering the gate line GL and the gate electrode 12G. An i-type semiconductor layer 14 made of a-Si is formed on the gate-insulating film 13. An n-type semiconductor layer 15 made of a-Si doped with an n-type impurity is formed on the i-type semiconductor layer 14. Further, a contact layer 19 made of Cr or the like and provided for a source and a drain is formed on the n-type semiconductor layer 15.

### [Step 3]

As is shown in Fig. 3B, the contact layer 19, the n-type semiconductor layer 15, and the i-type semiconductor layer 14 are patterned by photolithography, thereby forming a transistor region.

### [Step 4]

Then, as is shown in Fig. 3C, a transparent conductive film 18 made of ITO or the like is formed on the gate-insulating film 13, covering the patterned layers 16, 15 and 14. Further, a metal film 16 made of Al or an Al alloy is formed on the conductive film 18. The metal film 16 will be processed to form a source electrode and a drain electrode.

### [Step 5]

As can be understood from Fig. 3D, the metal film 16 and the transparent conductive film 18 are patterned by photolithography, forming a pixel electrode 18a, a source electrode 16S, a drain electrode 16D, and a drain line DL (see Fig. 4). Using the resist mask 21 used in patterning the films 16 and 18, the contact layer 19 is etched partly and divided into two portions, which are located below the source electrode 16S and the drain electrode 16D, respectively. In other words, that portion of the contact layer 19, which is not covered with the metal film 16 and the transparent conductive film 18, is removed by etching, thereby forming two portions which are substantially identical in size and shape to the electrodes 16S and 16D, respectively.

The source electrode 16S and the drain electrode 16D, which have been formed in Steps 3, 4, and 5, consist of three layers each, i.e., a part of the contact layer 19, a part of the conductive film 18, and a part of the metal film 16. The drain line DL consists of two layers, a part of the conductive film 18 and a part of the metal film 16.

### [Step 6]

Next, as is shown in Fig. 3D, using the resist mask 21 used in patterning the metal film 16 and the conductive film 18, that portion of the n-type semiconductor layer 15 which extends between the electrodes 16S and 16D is oxidized anodically. This portion of the layer 15, which is now insulative, electrically isolates the resulting two portions of the layer 15. As a result, a thin-film transistor element 10 is formed.

The anodic oxidation of the n-type semiconductor layer 15 is achieved by immersing the substrate 11 in an electrolytic solution, opposing the layer 15, acting as anode, to a platinum electrode (not shown) also immersed in the electrolytic solution and functioning as cathode, and applying a voltage between the layer 15 and the platinum electrode. That portion of the layer 15, which is not covered with the resist mask 21 and which contacts the electrolytic solution, undergoes a chemical reaction and is oxidized anodically. This portion of the n-type semiconductor layer 15 is thereby changed to an insulation layer 15a.

The depth or thickness to which the n-type semiconductor layer 15 is oxidized depends, mainly on the voltage applied between the layer 15 and the platinum electrode. Hence, the selected portion of the layer 15 is anodically oxidized in its entirely, provided that a voltage proportional to the thickness of the layer 15 is applied between the n-type semiconductor layer 15 and the platinum electrode (not shown). This is why the two parts of the layer 15, located beneath the electrodes 16S and 16D, are electrically isolated from each other.

An electric current can be supplied to the layer 15 in order to anodically oxidize said portion of the layer 15, through the transparent conductive film 18, the drain line DL (i.e., a part of the metal film 16) formed on the film 18, and the contact layer 19 for the drain electrode 16D. Therefore, not only the n-type semiconductor layer 15 of the thin-film transistor 10, but also the n-type semiconductor layers of other thin-film transistors (not shown), which are arranged along the data line DL, can be anodically oxidized uniformly.

### [Step 7]

Next, the resist mask 21 is removed, and a protective insulation film 17 made of SiN or the like is formed on the substrate 11, thus covering all components formed on the substrate 11, as is shown in Fig. 3E.

### [Step 8]

As is shown in Fig. 3E, too, the protective insulation film 17 is patterned by photolithography, such that its portion on the pixel electrode 18a, its portion on the terminal portion DLa of the drain line DL, and its portion on the terminal portion GLa of the gate line GL were removed. At the same time, that portion of the gate-insulating film 13 which is located on the terminal portion GLa of the gate line GL is removed by means of etching, thereby exposing the pixel electrode 18a, the terminal portion DLa of the drain line DL, and the terminal portion GLa of the gate line GL.

### [Step 9]

Then, as can be understood from Fig. 3F, using the resist mask (not shown) once used in patterning the insulation films 17 and 13, that portion of the metal film 16 which is located on the pixel electrode 18a is removed by etching. Thereafter, the resist mask is removed, whereby a TFT panel is manufactured.

In the method according to the aforementioned embodiment of the invention, the upper film (i.e., a part of the film 16) of the terminal portion DLa and the upper film 12b (made of Al or an Al alloy) of the terminal portion GLa, both already exposed by patterning the insulation films 17 and 13, are etched when that portion of the metal film 16 which is formed on the pixel electrode 18a is etched. Nonetheless, the lower film 18 of the terminal portion DLa and the lower film 12a of the terminal portion GLa, both made of ITO or the like, are hardly etched since they are much harder to etch than the upper films of the terminal portions DLa and GLa. The lower films 18 and 12a therefore remain intact, and function as the terminal portions DLa and GLa, respectively.

In the embodiment, the portion of the n-type semiconductor layer 15, which extends between the source and drain electrodes 16S and 16D, is anodically oxidized, becoming an insulative layer. This insulative layer electrically divides the n-type layer 15 into two conductive layers. Since no part of the n-type semiconductor layer 15 is not removed by etching as in the prior-art method, the i-type semiconductor layer 14 is not damaged during the manufacture of the TFT panel even if a blocking layer is not formed on the channel region of the layer 14. Hence, a step of forming a blocking layer is not necessary in this method, either.

Further, only four resist films need to be formed whereas five resist masks must be formed in the conventional method. More specifically, the four resist masks are formed, respectively before:
(1) The gate metal film 12 is patterned to form the upper and lower layers 12a and 12b;
(2) The contact layer 19, the n-type semiconductor layer 15, and the i-type semiconductor layer 14 are patterned to form the transistor region;
(3) The metal film 16 and the transparent conductive film 19 are patterned, the contact layer 19 is etched partly and divided into two portions, and the selected portion of the n-type semiconductor layer 15 is oxidized anodically;
(4) The protective insulation film 17 is patterned, that portion of the gate-insulating film 13 which is located on the terminal portion GLa of the gate line GL is removed, and that portion of the metal film 16 which is located on the pixel electrode 18a.

Therefore, the TFT panel can be manufactured by this method with higher efficiency and, thus, at lower cost, than is possible with the conventional method. Further, since no blocking layer needs to be formed on the channel region of the i-type semiconductor layer 14, TFT panels can be manufactured by the method at a higher yield than is possible with the prior-art method.

As has been described, the gate line GL and the gate electrode 12G are of two-layered structure in this embodiment, each comprised of a lower film 12a made of ITO or the like and an upper film 12b made of Al or an Al alloy. Instead, the lower film 12a may be made of Al or an Al alloy, and the upper film 12b may be made of ITO or the like, so that the terminal portion GLa of the gate line GL can remain in the form of a two-layered film.

Moreover, the gate line GL and the gate electrode 12G can be formed of only one metal film each. In the case where the line GL and the electrode 12G consist of a single metal film each, the terminal portion GLa of the gate line GL will not be etched away when the metal film 16 is partly removed to form the electrodes 16S and 16D, provided that said metal film is harder to etch than the metal film 16 or is anodically all over its surface.

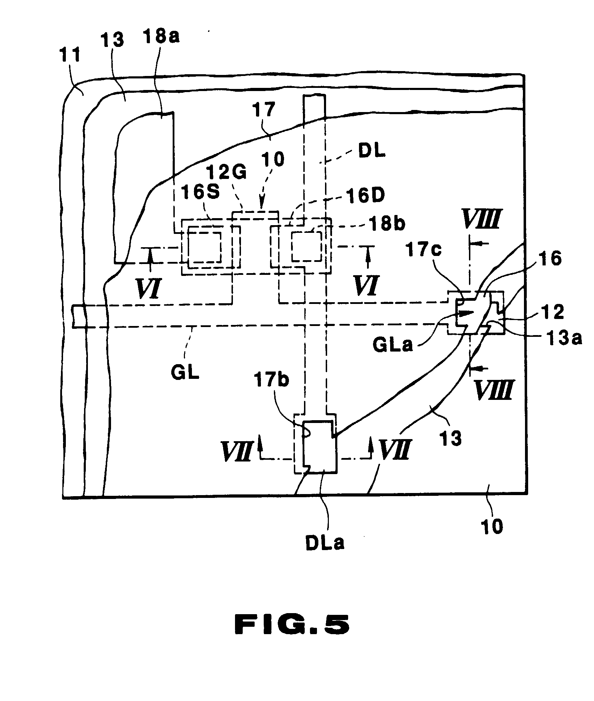

A further method of manufacturing a TFT panel will now be described with reference to Figs. 5 to 8 and Figs. 9A to 9H.

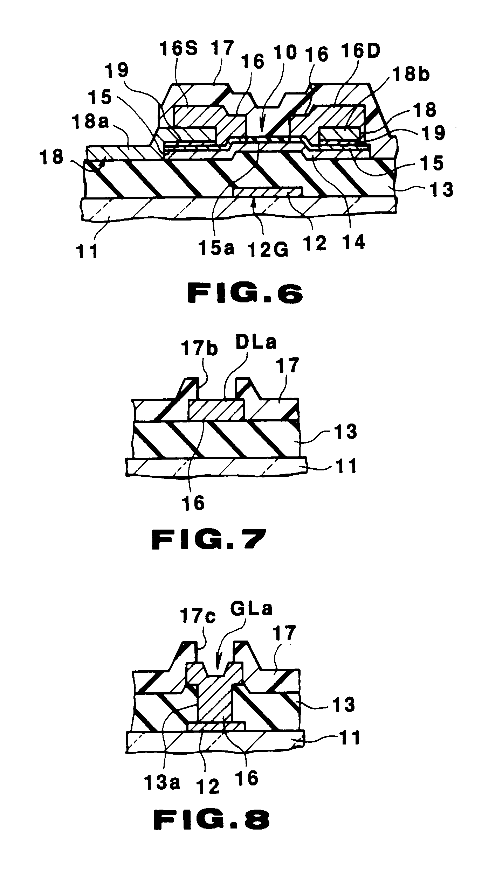

The TFT panel manufactured by this method will be described first, with reference to Figs. 5 to 8. Fig. 5 is a plan view of the panel, and Figs. 6 to 8 are enlarged, cross-sectional views of the panel, taken along line XI-XI, line VII-VII and line VIII-VIII in Fig. 5, respectively.

This TFT panel comprises a transparent substrate 11 made of glass or the like, a pixel electrode 18a formed on the substrate 11, and a thin-film transistor (TFT) element 10 formed on the substrate 11 and functioning as an active element for the electrode 18a.

As is clearly seen from Figs. 5 and 6, the thin-film transistor element 10 comprises a gate electrode 12G formed on the substrate 11, a gate-insulating film 13 covering the gate electrode 12G, an i-type semiconductor layer 14 formed on a portion of the gate-insulating film 13, an n-type semiconductor layer 15 formed on the i-type semiconductor layer 14, a contact layer 19 formed on the n-type semiconductor layer 15, a source electrode 16S formed on the contact layer 19, and a drain electrode 16D formed on the contact layer 19.

The i-type semiconductor layer 14 is made of a-Si, the n-type semiconductor layer 15 is made of a-Si doped with an n-type impurity, and the contact layer 19 is formed of metal such as Cr.

The gate electrode 12G is integral with a gate line GL formed on the substrate 11. The gate-insulating film 13 covers both the gate electrode 12G and the gate line GL, and is formed on almost the entire surface of the substrate 11. The film 13 is made of SiN or the like. Formed on the gate-insulating film 13 is a data line DL which is connected to the drain electrode 16D. The gate electrode 12G and the gate line GL are formed of a gate metal film 12 which is made of aluminum or an aluminum alloy. The source electrode 16S, the drain electrode 16D, and the data line DL are formed of a drain metal film 16 which is made of aluminum or an aluminum alloy.

The pixel electrode 18a is formed on the gate-insulating film (i.e., a transparent film) 13. The electrode 18a is formed of a transparent conductive film 18 made of ITO or the like. It has an end portion formed interposed between the source contact layer 19 and source electrode 16S of the thin-film transistor element 10 and, hence, connected to the the source electrode 16S. That end portion of the pixel electrode 18a has an area smaller than that of the source electrode 16S. The source electrode 16S has a portion which does not contact the end portion of the pixel electrode 18a and which directly contacts the n-type semiconductor layer 15.

A conductive layer 18b made of the same transparent material (i.e., ITO or the like) as the pixel electrode 18a is interposed between the drain electrode 16D of the thin-film transistor element 10 and the contact layer 19 located below the drain electrode 16D. Those portions of the contact layer 19, which are located below the source and drain electrodes 16S and 16D of the transistor element 10, respectively, are identical in shape to the terminal portion of the electrode 18a and the conductive layer 18b, respectively. The conductive layer 18b and that portion of the contact layer 19, located below the drain electrode 16D, have an area each, which is smaller than that of the drain electrode 16D, and is covered with the drain electrode 16D. That portion of the drain electrode 16D, which does not cover the conductive layer 18b, contacts the n-type semiconductor layer 15 directly.

The n-type semiconductor layer 15 of the thin-film transistor element 10 is formed on the entire surface of the i-type semiconductor layer 14. That portion of the layer 15, which extends between the source electrode 16S and the drain electrode 16D, has been anodically oxidized in its entirety and, hence, is an insulative layer 15a.

The TFT panel has a protective insulation film 17 which is a top layer, is transparent and made of SiN or the like. As is shown in Figs. 5 and 7, the film 17 has an opening 17b. Though this opening 17b, the terminal portion DLa of the data line DL is exposed.

As is shown in Figs. 5 and 8, the terminal portion GLa of the gate line GL consists of two layers. The lower layer is a part of the gate metal film 12, and the upper film is a part of the metal film 16. The metal film 16 is laid on the lower film (i.e., a part of the gate metal film 12), filling up the opening 13a made in the gate-insulating film 13. The terminal portion GLa is exposed through the opening 17b made in the protective insulation film 17.

The TFT panel is characterized in that the portion of the n-type semiconductor layer 15, which extends between the source electrode 16S and the drain electrode 16D, is anodically oxidized, forming the insulative layer 15a which divides the layer 15 into two parts electrically isolated from each other and provided for the source and drain of the thin-film transistor 10, respectively.

As has been indicated above, the pixel electrode 18a is interposed between the source electrode 16S and that portion of the contact layer 19 located below the source electrode 16S, and the conductive layer 18b is interposed between the drain electrode 16D of the thin-film transistor 10 and the contact layer 19 located below the drain electrode 16D. Both the electrode 18a and the conductive layer 18b are made of the same transparent material. Further, those portions of the contact layer 19, which are located below the source and drain electrodes 16S and 16D of the transistor 10, respectively, are identical in shape to the terminal portion of the electrode 18a and the conductive layer 18b, respectively. Therefore, the pixel electrode 18a and the contact layer 19 can be patterned in one and the same step.

It will now be explained how the TFT panel is manufactured, with reference to Figs. 9A to 9H which are cross-sectional views of the TFT panel.

### [Step 1]

First, as is shown in Fig. 9A, the gate electrode 12G and the gate line GL (see Fig. 5) are formed on the substrate 11 made of glass or the like. The electrode 12G and the gate line GL are formed by depositing the gate metal film 12 on the substrate 11 and patterning the film 12 by means of photolithography. The metal film 12 shown at the upper-right corner of Fig. 9A is a part of the metal film 12 which is the lower film of the terminal portion GLa of the gate line GL.

### [Step 2]

As is shown in Fig. 9A, too, the gate-insulating film 13 is formed on the substrate 11, covering the gate electrode 12G and the gate line GL. The i-type semiconductor layer 14 is formed on the gate insulating film 13. The n-type semiconductor layer 15 is formed on the i-type semiconductor layer 14. The contact layer 19 is formed on the n-type semiconductor layer.

### [Step 3]

Next, as is shown in Fig. 9B, the contact layer 19, the n-type semiconductor layer 15, and the i-type semiconductor layer 14 are patterned by photolithography, whereby these layers 19, 15, and 14 come to have the shape and size identical to a transistor region to be formed.

### [Step 4]

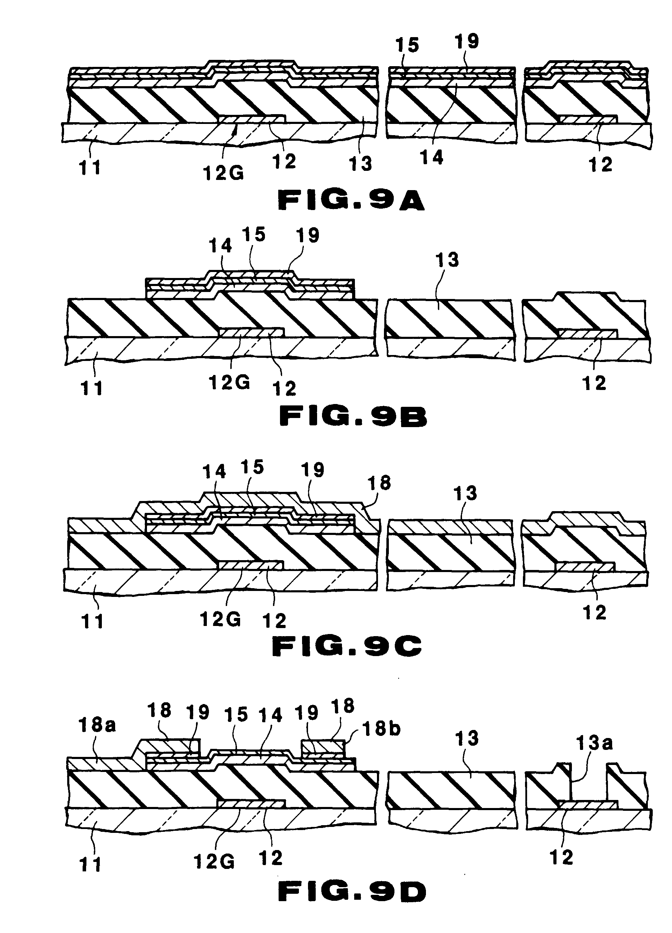

As is shown in Fig. 9C, the transparent conductive film 18 made of ITO or the like is formed on the substrate 11 an the gate-insulating film 13, covering the layers 14, 15, and 19 which have been patterned.

### [Step 5]

As is shown in Fig. 9D, the transparent conductive film 18 is patterned by photolithography, thereby forming the pixel electrode 18a having a terminal portion located at the position where the source electrode 16S will be formed, and also forming the conductive layer 18b located at the position where the drain electrode 16D will be formed. Further, the contact layer 19 is patterned, into two contact layers which have the same shape and size as the pixel electrode 18a and the conductive layer 18b, respectively. The terminal portion of the pixel electrode 18a and the contact layer located in the source region have an area smaller than the source-electrode region. The conductive layer 18b and the contact layer located in the drain region are located fully within the drain-electrode region and have an area smaller than the drain-electrode region.

### [Step 6]

As can be seen from Fig. 9D, too, an opening 13a is made in the gate-insulating film 13 by means of photolithography, thereby exposing the terminal portion GLa of the gate line GL (i.e., a part of the gate metal film 12).

### [Step 7]

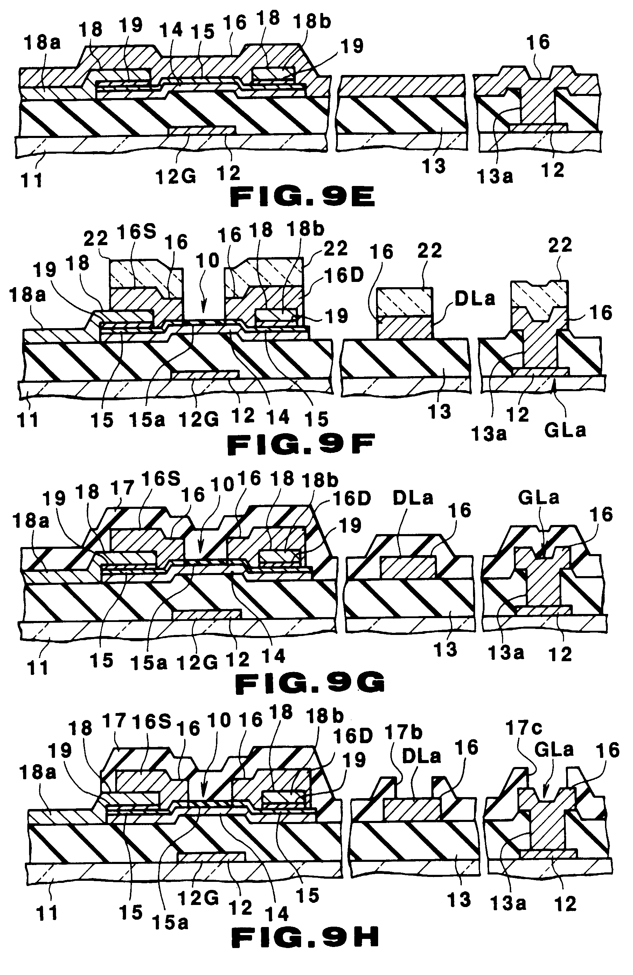

Next, as is shown in Fig. 9E, the metal film 16, which will be patterned to form the source electrode 16S and the drain electrode 16D, is formed on the gate-insulating film 13, covering the patterned transparent conductive film 18 and the like, and also filling the opening 13a made in the gate-insulating film 13.

### [Step 8]

As is shown in Fig. 9F, the metal film 16 is patterned by photolithography, forming the source electrode 16S, the drain electrode 16D, the data line DL (see Fig. 15), and the upper film of the terminal portion GLa of the gate line GL. Both the source electrode 16S and the drain electrode 16D are large enough to cover the terminal portion of the pixel electrode 18a and the conductive layer 18b, respectively. In Fig. 17F, the terminal portion DLa of the data line DL is formed of the metal film 16 only.

### [Step 9]

Then, as is shown in Fig. 9F, using the resist mask 23 which has been used in patterning the metal film 16, that portion of the n-type semiconductor layer 15, which extends between the source electrode 16S and the drain electrode 16S, is anodically oxidized in its entirety, forming the insulative layer 15a. This layer 15a divides the layer 15 into two parts electrically isolated from each other, whereby the thin-film transistor element 10 is made. The anodic oxidation of said portion of the layer 15 is performed in the same way as described above.

An electric current can be supplied to the layer 15 in order to achieve the anodic oxidation, through the data line DL and the drain electrode 16D. Therefore, the n-type semiconductor layers of all thin-film transistors (not shown) that are arranged along the data line DL, can be anodically oxidized uniformly. Since a resist mask 22 does not cover neither the sides of the drain electrode 16D nor the sides of the data line DL, the sides of both the electrode 16D and those of the data line DL are oxidized anodically. (The resultant oxide layers are not shown.) Nonetheless, the center portion of the electrode 16D or the center portion of the data line DL is not oxidized at all.

If the conductive layer 18b located beneath the drain electrode fourth 16D extends outwards from the drain electrode 16D and, thus, had an exposed portion, an electric current would flow between this exposed portion of the layer 18b and the platinum electrode during the anodic oxidation. (The current would continuously flow between the exposed portion of the layer 18b and the platinum electrode since the layer 18b is made of an oxide, i.e., ITO or the like.) Consequently, virtually no current would flow to the n-type semiconductor layer 15 and could not be anodically oxidized. Since the drain electrode 16D is large, covering up the conductive layer 18b, an electric current flows between the n-type semiconductor layer 15 and the platinum electrode, whereby that portion of the layer 15 which extends between the electrodes 16S and 16D is oxidized anodically.

### [Step 10]

Then, the resist mask 22 is removed, and the protective insulation film 17 is formed as is shown in Fig. 9G.

### [Step 11]

As is shown in Fig. 9H, the protective film 17 is patterned by photolithography, forming openings 17a and 17b in the film 17, thereby exposing the terminal portion DLa of the data line DL an the terminal portion GLa of the gate line GL, respectively. The TFT panel is thereby manufactured.

In the method herein described the contact layer 19 is patterned into two parts identical in shape and size to the terminal portion of the pixel electrode 18a and the conductive layer 18b, respectively, in order to pattern the transparent conductive film 18 thereby to form the pixel electrode 18a and the conductive layer 18b on those portions of the metal film 16 which will be the source electrode 16S and the drain electrode 16D, respectively. Also, the n-type semiconductor layer 15 is anodically oxidized by the use of the resist mask 22 once used in patterning the metal film 16, whereby that portion of the layer 15 between the electrodes 16S and 16D becomes the insulation layer 15a. Hence, it suffices to form less resist masks than is required in the conventional method of manufacturing TFT panels of the same type. More specifically, six resist masks are formed, respectively before:
(1) The gate metal film 12 is patterned;
(2) The contact layer 19, the n-type semiconductor layer 15, and the i-type semiconductor layer 14 are patterned to form the transistor region;
(3) The transparent conductive film 18 and the contact layer 19 beneath the film 18 are patterned;
(4) The opening 13a is formed in the gate-insulating film 13;
(5) The metal film 16 is patterned, and the n-type semiconductor layer 15 is anodically oxidized partly;
(6) The openings 17b and 17c are formed in the protective insulation film 17.

Therefore, the TFT panel can be manufactured by this method with higher efficiency and, thus, at lower cost, than is possible with the conventional method.

As has been described, the terminal portion GLa of the gate line GL is of two-layered structure comprised of a lower film formed of a part of the gate metal film 12 and an upper film formed of a part of the metal film 16. Instead, the terminal portion GLa may be comprised of a part of the gate metal film 12 only. If the portion GLa is made so, the opening 13a can be formed at the same time the openings 17b and 17a are formed in the protective insulation film 17. In this case, Step 6 need not be carried out, whereby the number of resist masks required is reduced by one.

The portion of the n-type that portion of the n-type semiconductor layer 15, which extends between the source electrode 16S and the drain electrode 16D, is oxidized in an electrolytic solution bath. Instead, this portion of the layer 15 can be oxidized by plasma oxidation which is performed in a gas atmosphere.

## Claims

1. A method of manufacturing a thin-film transistor panel, comprising the following steps:
a first step of forming an insulating substrate (11) having a gate electrode (12G) formed thereon, a gate-insulating film (13) formed on the insulating substrate (11) and the gate electrode (12G), an i-type semiconductor film (14) formed on the gate-insulating film (13), and an n-type semiconductor film (15) formed on the i-type semiconductor film (14);
a second step of patterning the n-type semiconductor film (15) and the i-type semiconductor film (14) so as to have an element shape;
a third step of forming a transparent conductive film (18) on the resultant structure;
a fourth step of forming an electrode-forming film (16) on the transparent conductive film (18);
a fifth step of patterning the electrode-forming film (16) into drain and source electrodes (16S, 16D) and a portion covering a pixel electrode (18a), and of patterning the transparent conductive film (18) into portions corresponding to the drain and source electrodes (16D, 16S) and a portion forming a pixel electrode (18a);
a sixth step of oxidizing that portion of the n-type semiconductor film (15) which is located in a channel region, thereby forming an insulating film (15a) electrically isolating those portions of the n-type semiconductor film (15) which are located beneath the source electrode (16S) and the drain electrode (16D) ;
a seventh step of forming a protective insulating film (17) on the resultant structure; and
an eighth step of patterning the protective insulating film (17) and the electrode-forming film (16) so as to remove the portions of the protective insulating film (17) and the electrode-forming film (16) on the pixel electrode (18a),
characterized in that
the gate electrode (12G) includes a gate line (GL) having a terminal portion (GLa);
the fifth step patterns the electrode-forming film (16) and the transparent conductive film (18) to form a drain line (DL) which is connected to the drain electrode (16D) and having a terminal portion (DLa); and
the eighth step removes the portions of the protective insulating film (17) and the gate-insulating film to expose the terminal portions (GLa, DLa) of the gate and the drain lines (GL, DL).

2. The method of manufacturing a thin-film transistor panel according to claim 1, characterized in that the gate electrode (12G) and gate line (GL) are formed of a transparent conductive film (12a) and a metal film (12b) stacked with each other, and
the eighth step removes the portions of the protective insulating film (17), the gate-insulating film, and the metal film (12b) of the terminal portion (GLa) of the gate line (GL) to expose the transparent conductive film (12a), and removes the portions of the protective insulating film (17) and a terminal portion of the electrode-forming film (16) to expose the terminal portion of the transparent conductive film (18).

3. The method of manufacturing a thin-film transistor panel according to claims 1 or 2, characterized by further comprising a step of forming a contact film (19) on the n-type semiconductor film (15), and characterized in that,
the second step patterns the contact film (19) as well as the n-type semiconductor film (15) and the i-type semiconductor film (14) so as to have the element shape;
the third step forms the transparent conductive film (18) on the contact film (19); and
the fifth step patterns the contact film (19) as well as the electrode forming film (16) and the transparent conductive film (18).

4. A thin-film transistor panel comprising:
an insulating substrate (11);
a thin-film transistor element (10) formed on the insulating substrate (11) and including:
a gate electrode (12G);
a gate line (GL) connected to the gate electrode (12G);
a gate-insulating film (13) having a contact hole connected to the terminal portion (GLa) of the gate line (GL) ;
an i-type semiconductor film (14) to face the gate electrode (12G) through the gate-insulating film (13) therebetween;
a first n-type semiconductor film (15) formed on a source region of the i-type semiconductor film (14);
a second n-type semiconductor film (15) formed on a drain region of the i-type semiconductor film (14);
a source electrode (16S) electrically connected to the source region of the i-type semiconductor film (14), through the first n-type semiconductor film (15);
a drain electrode (16D) electrically connected to the drain region of the i-type semiconductor film (14) through the second n-type semiconductor film (15); and
an insulating film (15a) located between the source and drain electrodes to electrically isolate the source and drain electrodes;
a pixel electrode (18a) formed of transparent conductive material (ITO) and electrically connected to the source electrode (16S) ;
a drain line (DL) connected to the drain electrode (16D); and
a protective insulating film (17) formed on the transistor element (10) having an opening on the pixel electrode (18a);
characterized in that
the gate line (GL) is formed of a transparent conductive film (12a) and a metal film (12b) formed on the transparent conductive film (12a), and having a terminal portion at which the metal film is removed to expose the transparent conductive film (12a),
the drain line (DL) is formed of a conductive transparent film (18) and a metal film (16) formed on the transparent conductive film (18), and having a terminal portion (DLa) at which the metal film (16) is removed to expose the transparent conductive film (18), and
the gate-insulating film (13) and the protective insulating film (17) have openings in the terminal portions (GLa, DLa) of the gate and drain lines (GL, DL).

5. The transistor panel according to claim 4, characterized by further comprising a contact film (19) formed between the pixel electrode (18a) and the first n-type semiconductor film (15).

## Patentansprüche

1. Verfahren zum Herstellen eines Dünnschichttransistorpanels, das die folgenden Schritte aufweist:
einen ersten Schritt zum Bilden eines isolierenden Substrats (11) mit einer darauf gebildeten Gateelektrode (12G), einer auf dem isolierenden Substrat (11) und der Gateelektrode (12G) gebildeten Gateisolierschicht (13), einer auf der Gateisolierschicht (13) gebildeten Eigenhalbleiterschicht (14) und einer auf dem Eigenhalbleiterschicht (14) gebildeten n-Halbleiterschicht (15),
einen zweiten Schritt zum Strukturieren der n-Halbleiterschicht (15) und der Eigenhalbleiterschicht (14), um eine Elementform zu erzielen,
einen dritten Schritt zum Bilden einer transparenten Leitschicht (18) auf der resultierenden Struktur,
einen vierten Schritt zum Bilden einer Elektroden-bildenden Schicht (16) auf der transparenten Leitschicht (18),
einen fünften Schritt zum Strukturieren der Elektroden-bildenden Schicht (16) in eine Drainelektrode (16D) und eine Sourceelektrode (16S) und einen Teil, der eine Pixelelektrode (18a) bedeckt, sowie zum Strukturieren der transparenten Schicht (18) in Teile, die der Drainelektrode (16D), der Sourceelektrode (16S) und einem Teil, der eine Pixelelektrode (18a) bildet, entsprechen,
einen sechsten Schritt zum Oxidieren des Teils des n-Halbleiterschicht (15), der in einem Kanalbereich lokalisiert ist, wobei eine Isolierschicht (15a) gebildet wird, die die Teile der n-Halbleiterschicht (15) elektrisch isoliert, die unter der Sourceelektrode (16S) und der Drainelektrode (16D) lokalisiert sind,
einen siebten Schritt zum Bilden einer Schutzisolierschicht (17) auf der resultierenden Struktur, und
einen achten Schritt zum Strukturieren der Schutzisolierschicht (17) und der Elektroden-bildenden Schicht (16), um die Teile der Schutzisolierschicht (17) und der Elektroden-bildenden Schicht (16) auf der Pixelelektrode (18a) zu entfernen,
dadurch gekennzeichnet, daß
die Gateelektrode (12G) eine Gateleitung (GL) mit einem Endteil (GLa) aufweist,
der fünfte Schritt die Elektroden-bildenden Schicht (16) und die transparente Leitschicht (18) strukturiert, um eine Drainleitung (DL) zu bilden, die mit der Drainelektrode (16D) verbunden ist und ein Endteil (DLa) aufweist, und der achte Schritt die Teile des Schutzisolierschicht (17) und der Gateisolierschicht entfernt, um die Endteile (GLa, DLa) der Gate- und Drainleitungen (GL, DL) freizulegen.

2. Verfahren zum Herstellen eines Dünnschichttransitorpanels nach Anspruch 1, dadurch gekennzeichnet, daß die Gateelektrode (12G) und die Gateleitung (GL) aus einer transparenten Leitschicht (12a) und einer Metallschicht (12b), die übereinander geschichtet sind, gebildet werden, und
der achte Schritt Teile der Schutzisolierschicht (17), der Gateisolierschicht und der Metallschicht (12b) des Endstücks (GLa) der Gateleitung (GL) entfernt, um die transparente Leitschicht (12a) freizulegen, und Teile der Schutzisolierschicht (17) und ein Endstück des Elektroden-bildenden Schicht (16) entfernt, um das Endstück des transparenten Leitschicht (18) freizulegen.

3. Verfahren zum Herstellen eines Dünnschichttransistorpanels nach Anspruch 1 oder 2, dadurch gekennzeichnet, daß es weiterhin einen Schritt zum Bilden einer Kontaktschicht (19) auf der n-Halbleiterschicht (15) aufweist, und dadurch gekennzeichnet, daß
der zweite Schritt die Kontaktschicht (19), die n-Halbleiterschicht (15) und die Eigenhalbleiterschicht (14) strukturiert, so daß diese die Form des Elements aufweisen,
der dritte Schritt die transparente Leitschicht (18) auf der Kontaktschicht (19) bildet, und
der fünfte Schritt die Kontaktschicht (19), die Elektroden-bildende Schicht (16) und die transparente Leitschicht (18) strukturiert.

4. Dünnschichttransistorpanel mit
einem isolierenden Substrat (11),
einem auf dem isolierenden Substrat (11) gebildeten Dünnschichttransistorelement (10) mit
einer Gateelektrode (12G),
einer mit der Gateelektrode (12G) verbundenen Gateleitung (GL),
einer Gateisolierschicht (13), die ein mit dem Endstück (GLa) der Gateleitung verbundenes Kontaktloch aufweist,
einer Eigenhalbleiterschicht (14) über der Gateelektrode (12G) und der Gateisolierschicht (13),
einer ersten n-Halbleiterschicht (15), die auf dem Sourcebereich der Eigenhalbleiterschicht (14) gebildet ist,
einer zweiten n-Halbleiterschicht (15), die auf dem Drainbereich der Eigenhalbleiterschicht (14) gebildet ist,
einer Sourceelektrode (16S), die elektrisch mit dem Sourcebereich der Eigenhalbleiterschicht (14) durch die erste n-Halbleiterschicht (15) verbunden ist,
einer Drainelektrode (16D), die elektrisch mit dem Drainbereich der Eigenhalbleiterschicht (14) durch die zweite n-Halbleiterschicht (15) verbunden ist,
einer Isolierschicht (15a), die zwischen der Sourceelektrode und der Drainelektrode angeordnet ist, um die Sourceelektrode und die Drainelektrode elektrisch voneinander zu isolieren,
einer Pixelelektrode (18a), die aus einem transparenten leitenden Material (ITO) gebildet ist und elektrisch mit der Sourceelektrode (16S) verbunden ist,
einer mit der Drainelektrode (16D) verbundenen Drainleitung (DL), und
einer auf dem Transistorelement gebildeten Schutzisolierschicht (17), die eine Öffnung auf der Pixelelektrode (18a) aufweist,
dadurch gekennzeichnet, daß
die Gateleitung (GL) aus einer transparenten Leitschicht (12a) und einer auf der transparenten Leitschicht (12a) gebildeten Metallschicht (12b) gebildet ist und ein Endstück aufweist, an dem die Metallschicht entfernt ist, um die transparente Leitschicht (12a) freizulegen,
die Drainleitung (DL) aus einer transparenten Leitschicht (18) und einer auf der transparenten Leitschicht (18) gebildeten Metallschicht (16) gebildet ist und ein Endstück (DLa) aufweist, bei dem die Metallschicht (16) entfernt ist, um die transparente Leitschicht (18) freizulegen, und
die Gateisolierschicht (13) und die Schutzisolierschicht (17) Öffnungen in den Endstücken (GLa, DLa) der Gateleitung (GL) und der Drainleitung (DL) aufweisen.

5. Transistorpanel nach Anspruch 4, dadurch gekennzeichnet, daß das Panel weiterhin eine zwischen der Pixelelektrode (18a) und der ersten n-Halbleiterschicht (15) gebildete Kontaktschicht (19) aufweist.

## Revendications

1. Méthode de fabrication d'un panneau de transistor à couches minces, comprenant les étapes suivantes :
une première étape de formation d'un substrat isolant (11) sur lequel est formée une électrode de grille (12G), une couche isolant la grille (13) formée sur le substrat isolant (11) et l'électrode de grille (12G), une couche de semi-conducteur du type I (14) formée sur la couche isolant la grille (13), et une couche de semi-conducteur du type N (15) formée sur la couche de semi-conducteur du type I (14);
une deuxième étape de formation des motifs de la couche de semi-conducteur du type N (15) et de la couche de semi-conducteur du type I (14) afin d'obtenir une forme d'élément;
une troisième étape de formation d'une couche conductrice transparente (18) sur la structure résultante;
une quatrième étape de formation d'une couche (16) formant électrode sur la couche conductrice transparente (18);
une cinquième étape de formation des motifs d'une couche (16) formant électrode dans les électrodes de drain et de source (16S, 16D) et une partie recouvrant une électrode d'élément d'image (18a), et de formation des motifs de la couche conductrice transparente (18) dans des parties correspondant aux électrodes de drain et de source (16D, 16S) et une partie formant une électrode d'élément d'image (18a);
une sixième étape d'oxydation de la partie de la couche de semi-conducteur du type N (15) qui est située dans la zone d'un canal, formant ainsi une couche isolante (15a) isolant électriquement les parties de la couche de semi-conducteur du type N (15) qui sont situées au-dessous de l'électrode de source (16S) et de l'électrode de drain (16D);
une septième étape de formation d'une couche isolante protectrice (17) sur la structure résultante; et
une huitième étape de formation des motifs de la couche isolante protectrice (17) et de la couche (16) formant électrode afin de retirer les parties de la couche isolante protectrice (17) et de la couche (16) formant électrode sur l'électrode d'élément d'image (18a),
caractérisée en ce que
l'électrode de grille (12G) comprend une ligne de grille (GL) ayant une partie terminale (GLa);
la cinquième étape forme les motifs de la couche (16) formant électrode et la couche conductrice transparente (18) pour former une ligne de drain (DL) qui est raccordée à l'électrode de drain (16D) et ayant une partie terminale (DLa);
et la huitième étape enlève les parties de la couche isolante protectrice (17) et de la couche isolant la grille afin d'exposer les parties terminales (GLa, DLa) des lignes de grille et de drain (GL, DL).

2. Méthode de fabrication d'un panneau de transistor à couches minces selon la revendication 1, caractérisée en ce que l'électrode de grille (12G) et la ligne de grille (GL) sont formées d'une couche conductrice transparente (1 2a) et d'une couche métallique (12b) empilées l'une sur l'autre, et
la huitième étape enlève les parties de la couche isolante protectrice (17), de la couche isolant la grille, et de la couche métallique (12b) de la partie terminale (GLa) de la ligne de grille (GL) pour exposer la couche conductrice transparente (12a), et enlève les parties de la couche isolante protectrice (17) et une partie terminale de la couche (16) formant électrode pour exposer la partie terminale de la couche conductrice transparente (18).

3. Méthode de fabrication d'un panneau de transistor à couches minces selon la revendication 1 ou 2, caractérisée en outre en ce qu'elle comprend une étape de formation d'une couche en contact (19) sur la couche de semi-conducteur du type N (15), et caractérisée en ce que,
la deuxième étape forme les motifs de la couche en contact (19), ainsi que de la couche de semi-conducteur du type N (15) et de la couche de semi-conducteur du type I (14) afin d'avoir la forme de l'élément;
la troisième étape forme la couche conductrice transparente (18) sur la couche en contact (19); et
la cinquième étape forme les motifs de la couche en contact (19), ainsi que de la couche (16) formant électrode et de la couche conductrice transparente (18).

4. Panneau de transistor à couches minces comprenant :
un substrat isolant (11);
un élément à transistor à couches minces (10) formé sur le substrat isolant (11) et comprenant :
une électrode de grille (12G);
une ligne de grille (GL) raccordée à l'électrode de grille (12G);
une couche isolant la grille (13) ayant un trou de contact relié à la partie terminale (GLa) de la ligne de grille (GL);
une couche de semi-conducteur du type I (14) faisant face à l'électrode de grille (12G) par la couche isolant la grille (13) placée entre eux;
une première couche de semi-conducteur du type N (15) formée sur une zone de source de la couche de semi-conducteur du type I (14);
une deuxième couche de semi-conducteur du type N (15) formée sur une zone de grille de la couche de semi-conducteur du type I (14);
une électrode de source (16S) raccordée électriquement à la zone de source de la couche de semi-conducteur du type I (14) par l'intermédiaire de la première couche de semi-conducteur du type N (15);
une électrode de drain (16D) raccordée électriquement à la zone de drain de la couche de semi-conducteur du type I (14) par l'intermédiaire de la deuxième couche de semi-conducteur du type N (15); et
une couche isolante (15a) placée entre les électrodes de source et de drain pour isoler électriquement les électrodes de source et de drain;
une électrode d'élément d'image (18a) formée d'un matériau conducteur transparent (ITO) et reliée électriquement à l'électrode de source (16S);
une ligne de drain (DL) reliée à l'électrode de drain (16D); et
une couche isolante protectrice (17) formée sur l'élément à transistor (10) ayant une ouverture sur l'électrode d'élément d'image (18a);
caractérisé en ce que
la ligne de grille (GL) est formée d'une couche conductrice transparente (12a) et d'une couche métallique (12b) formées sur la couche conductrice transparente (12a), et ayant une partie terminale sur laquelle la couche métallique est enlevée afin d'exposer la couche conductrice transparente (12a),
la ligne de drain (DL) est formée d'une couche conductrice transparente (18) et d'une couche métallique (16) formées sur la couche conductrice transparente (18), et ayant une partie terminale (DLa) sur laquelle la couche métallique (16) est enlevée afin d'exposer la couche conductrice transparente (18), et
la couche isolant la grille (13) et la couche isolante protectrice (17) ont des ouvertures dans !es parties terminales (GLa, DLa) des lignes de grille et de drain (GL, DL).

5. Panneau de transistor selon la revendication 4, caractérisé en ce qu'il comprend en outre une couche en contact (19) formée entre l'électrode d'élément d'image (18a) et la première couche de semi-conducteur du type N (15).
